# EUROPÄISCHE PATENTANMELDUNG

(11) **EP 4 686 073 A1**
(43) Veröffentlichungstag der Anmeldung: **28.01.2026**
(21) Anmeldenummer: 24190943.1
(22) Anmeldetag: 25.07.2024
(51) Int. Cl.: H02M 7/00, H02M 7/483, H05K 7/14

(54) **UMRICHTERANORDNUNG**

(71) Anmelder: Siemens Energy Global GmbH & Co. KG, 81739 München (DE)
(72) Erfinder: Hafermaas, Jörg, 91056 Erlangen (DE); Foehr, Matthias, 91077 Dormitz (DE); Giering, Gerald Franz, 90562 Kalchreuth (DE); Bullinger, Arthur, 90411 Nürnberg (DE); De Marinis, Luigi, 94036 Passau (DE)

(57) **Zusammenfassung**

Die Erfindung betrifft eine Umrichteranordnung (20) mit Schaltmodulen (SM), die in einer Reihenschaltung miteinander verbunden sind, wobei jedes Schaltmodul jeweils mehrere Halbleiterschalter, einen Energiespeicher sowie einen ersten und einen zweiten Schaltmodulanschluss zum Verbinden mit zwei weiteren Schaltmodulen aufweist, wobei die Schaltmodule in einer Tragestruktur (TS) angeordnet sind. Die Erfindung zeichnet sich dadurch aus, dass die Tragestruktur nebeneinander aufgestellte Turmscheiben (T15-T38) umfasst, so dass jedem Schaltmodul wenigstens ein waagerecht benachbartes, wenigstens ein vertikal benachbartes Schaltmodul sowie genau ein rückseitig benachbartes Schaltmodul zugeordnet sind, wobei jede Turmscheibe zwei Anschluss-Schaltmodule aufweist, so dass alle Schaltmodule mit Ausnahme der Anschluss-Schaltmodule mittels ihrer Schaltmodulanschlüsse ausschließlich mit ihnen vertikal oder rückseitig benachbarten Schaltmodulen verbunden sind.

## Beschreibung

Die Erfindung betrifft eine Umrichteranordnung mit Schaltmodulen, die in einer Reihenschaltung miteinander verbunden sind, wobei jedes Schaltmodul jeweils mehrere Halbleiterschalter, einen Energiespeicher sowie einen ersten und einen zweiten Schaltmodulanschluss zum Verbinden mit zwei weiteren Schaltmodulen aufweist, wobei die Schaltmodule in einer Tragestruktur angeordnet sind.

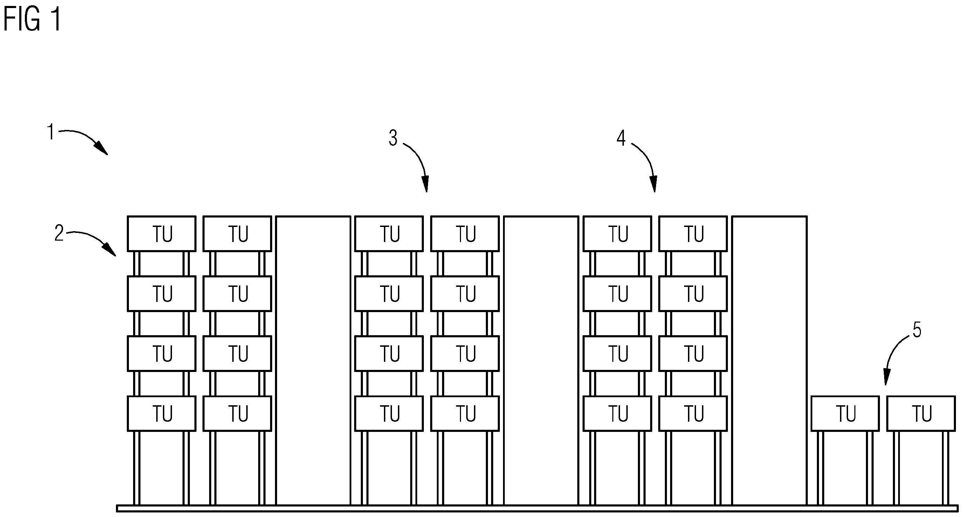

Die Umrichteranordnung kann beispielsweise pro Phase bzw. pro Umrichterarm eine solche Reihenschaltung von Schaltmodulen umfassen (dabei erstreckt sich ein Umrichterarm zwischen einem Gleichspannungspol und einem Wechselspannungsanschluss der Umrichteranordnung). Üblicherweise sind bei HVDC Umrichteranordnungen die Schaltmodule phasenweise in seriell verschaltete hintereinander aufgestellten Umrichtertürmen angeordnet. Die Anzahl der hintereinander verschalteten Umrichtertürme hängt von der Übertragungsleistung und -spannung der Umrichteranordnung ab, wobei jeder Umrichterturm bis zu einer Höhe von mehreren, beispielsweise vier Etagen und zur Aufnahme von bis zu hundert Schaltmodulen eingerichtet werden kann. Zwischen den einzelnen Umrichtertürmen innerhalb einer Phase ist einen Mindestabstand notwendig, der durch die elektrisch isolierende Luftstrecken bestimmt wird. Figur 1 zeigt eine Umrichteranordnung 1 mit einem solchen Aufbau. Die Umrichtertürme 2-5 tragen jeweils die Schaltmodule TU.

Eine eingangs genannte Umrichteranordnung ist beispielsweise auch aus der WO 2018/206134 bekannt.

Die Aufgabe der Erfindung ist es, eine eingangs genannte Umrichteranordnung vorzuschlagen, die möglichst kostengünstig ist.

Die Aufgabe wird bei der eingangsgenannten Umrichteranordnung erfindungsgemäß dadurch gelöst, dass die Tragestruktur nebeneinander aufgestellte Turmscheiben umfasst, so dass jedem Schaltmodul wenigstens ein in einer benachbarten Turmscheibe angeordnetes waagerecht benachbartes, wenigstens ein in derselben Turmscheibe angeordnetes vertikal benachbartes Schaltmodul sowie genau ein in derselben Turmscheibe angeordnetes rückseitig benachbartes Schaltmodul zugeordnet sind, wobei jede Turmscheibe zwei Anschluss-Schaltmodule aufweist, so dass alle Schaltmodule mit Ausnahme der Anschluss-Schaltmodule mittels ihrer Schaltmodulanschlüsse ausschließlich mit ihnen vertikal oder rückseitig benachbarten Schaltmodulen verbunden sind. Die Tragestruktur für die Schaltmodule umfasst demnach Teilstrukturen, die als Turmscheiben bezeichnet werden. Die Verschaltung der Schaltmodule wird innerhalb der Turmscheiben realisiert, mit Ausnahme der Anschluss-Schaltmodule, die die Schaltmodule zweier Turmscheiben miteinander verbinden. Die erfindungsgemäße Umrichteranordnung erlaubt es, den Nachteil des Standes der Technik zu vermeiden, wonach, falls ein Umrichterturm nur einen Bruchteil der höchstmöglichen Anzahl der Schaltmodule trägt, dieser Umrichterturm trotz seiner geringeren Bauhöhe die gesamte Grundfläche zur Aufstellung benötigt (vgl. Umrichterturm 5 in Figur 1). Durch die erfindungsgemäße Umrichteranordnung wird vorteilhaft eine bessere Skalierbarkeit deren räumlicher Anordnung erreicht, wodurch der Flächenbedarf annähernd linear mit einer gemäß der jeweiligen Anwendung notwendigen Anzahl von Schaltmodulen steigt und somit kleinere diskrete Schritte realisierbar sind. Einsparungen ergeben sich hierbei insbesondere aus der geringeren bebauten Grundfläche, die sich direkt auf die Größe der Umrichterhalle, in den üblicherweise die Umrichteranordnung bzw. der Umrichter untergebracht ist, und die benötigte Grundstücksfläche, zum Beispiel bei Offshore-Umrichtern auf die Größe der dort verwendeten Plattformen auswirken.

Gemäß einer Ausführungsform der Erfindung sind je Turmscheibe lediglich zwei rückseitig benachbarte Schaltmodule mittels ihrer Schaltmodulanschlüsse miteinander verbunden. Die Reihenschaltung der Schaltmodule innerhalb der Turmscheibe wird schematisch in einer U-Form realisiert. Ein erstes Anschluss-Schaltmodul, beispielsweise eines der beiden untersten Schaltmodule der Turmscheibe, ist mittels dessen ersten Schaltmodulanschlusses beispielsweise mit einem waagerecht benachbarten Schaltmodul einer benachbarten Turmscheibe sowie mittels dessen zweiten Schaltmodulanschlusses mit einem vertikal benachbarten Schaltmodul verbunden. Ein zum ersten Anschluss-Schaltmodul rückseitig benachbartes zweites Anschluss-Schaltmodul ist mittels dessen ersten Schaltmodulanschlusses beispielsweise mit einem waagerecht benachbarten Schaltmodul einer weiteren benachbarten Turmscheibe sowie mittels dessen zweiten Schaltmodulanschlusses mit einem vertikal benachbarten Schaltmodul verbunden. Die obersten beiden, rückseitig zueinander benachbarten Schaltmodule sind miteinander verbunden. Die übrigen Verbindungen zwischen Schaltmodulen der Turmscheibe verbinden vertikal benachbarte Schaltmodule. Diese Verschaltung erlaubt vorteilhaft besonders geringe Isolationsabstände und ist damit besonders platzsparend. Zudem wird relativ wenig Material für Stromschienen zum Verbinden der Schaltmodule benötigt.

Gemäß einer weiteren Ausführungsform der Erfindung sind die Schaltmodule mittels ihrer Schaltmodulanschlüsse jeweils mit dem ihnen zugeordneten rückseitig benachbarten Schaltmodul verbunden sind. Hierbei verläuft der Strompfad innerhalb einer Turmscheibe gemäße der Form eines Z. Jedes Schaltmodul ist mittels dessen ersten Schaltmodulanschlusses mit seinem rückseitig benachbarten Schaltmodul und mittels dessen zweiten Schaltmodulanschlusses mit einem darunter oder darüber angeordneten (jedoch nicht direkt benachbarten) Schaltmodul verbunden. Diese Anordnung erlaubt besonders geringe Isolationsabstände zwischen rückseitig benachbarten Schaltmodulen.

Vorzugsweise umfasst jede Turmscheibe zwischen zehn und zwanzig Schaltmodule. In den meisten Anwendungen erlaubt diese Anzahl an Schaltmodulen die beste Ausnutzung der vorhandenen räumlichen Kapazitäten.

Geeigneterweise umfasst die Umrichteranordnung mehr als zwanzig Turmscheiben. Auf diese Weise lassen sich Umrichteranordnungen realisieren, die eine DC-Spannung von mehr als 300 kV generieren können.

Zweckmäßigerweise umfasst jede Turmscheibe Isolatorbeine, die die Turmscheibe am Boden abstützen und die Schaltmodule der Turmscheibe vom Grundpotenzial elektrisch isolieren. Durch die Verwendung eigener Isolatorbeine für jede Turmscheibe ist die gesamte Anordnung modular erweiterbar. Die Turmscheiben können je nach Bedarf einfach hinzugefügt und an bereits aufgestellte Turmscheiben angefügt werden.

Die elektrische Topologie der Schaltmodule ist grundsätzlich frei und an die jeweilige Anwendung angepasst wählbar. Die Schaltmodule können beispielsweise dem Fachmann bekannte Halbbrücken- oder Vollbrückenschaltmodule sein. Halbbrückenschaltmodule umfassen zwei Leistungshalbleiterschalter und einen Energiespeicher, die derart miteinander verbunden sind, dass an den Schalmodul-Anschlüssen die Spannung am Energiespeicher oder eine Nullspannung erzeugbar sind. Vollbrückenschaltmodule umfassen vier Leistungshalbleiterschalter und einen Energiespeicher, die derart miteinander verbunden sind, dass an den Schalmodul-Anschlüssen die Spannung am Energiespeicher, in positiver oder negativer Polarität, oder eine Nullspannung erzeugbar sind.

Bevorzugt ist jedes Schaltmodul auf eine Spannung von mindestens 2kV, besonders bevorzugt auf mindestens 4kV ausgelegt. In diesem Spannungsbereich erlaubt die Umrichteranordnung die größten Raumersparnisse durch die vorteilhafte Anordnung der Schaltmodule.

Vorzugsweise weisen die Turmscheiben jeweils eine Höhe von mindestens 5m auf. Hierbei wird der vorhandene Raum für die Umrichteranordnung bei den meisten Anwendungen am besten ausgenutzt.

Geeigneterweise ist die Umrichteranordnung zum Umwandeln einer Wechselspannung in eine Gleichspannung oder umgekehrt eingerichtet. Dabei kann die Umrichteranordnung Teil eines HVDC-Systems sein. Es ist ebenfalls denkbar, dass die Umrichteranordnung gleichspannungsseitig eine Energiespeicheranordnung umfasst, so dass die Umrichteranordnung zum Stabilisieren eines Wechselspannungsnetzes eingerichtet ist, wobei die Umrichteranordnung Wirk- und Blindleistung mit dem Wechselspannungsnetz austauschen kann.

Die Erfindung wird nachfolgend im Zusammenhang mit in den Figuren 2 bis 10 dargestellten Ausführungsbeispielen weiter erläutert.
Figur 2 zeigt ein erstes Ausführungsbeispiel einer erfindungsgemäßen Umrichteranordnung in einer schematischen Darstellung;
Figuren 3 und 4 zeigen ein zweites Ausführungsbeispiel einer erfindungsgemäßen Umrichteranordnung in einer schematischen Darstellung;
Figuren 5 und 6 zeigen ein drittes Ausführungsbeispiel einer erfindungsgemäßen Umrichteranordnung in einer schematischen Darstellung;
Figuren 7, 8 und 9 zeigen ein viertes Ausführungsbeispiel einer erfindungsgemäßen Umrichteranordnung in einer schematischen Darstellung;
Figur 10 zeigt ein Beispiel eines Schaltmoduls für eine der Umrichteranordnungen der vorangehenden Figuren.

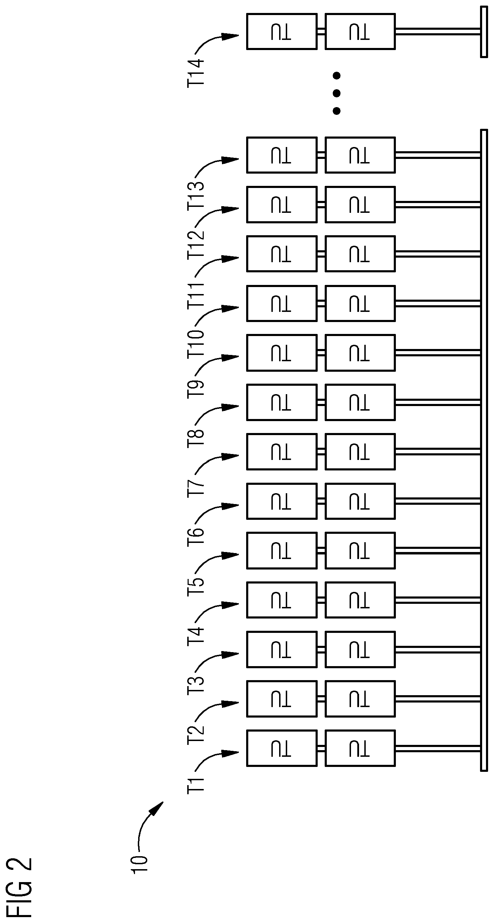

Figur 2 zeigt eine Umrichteranordnung 10 mit einer elektrischen Reihenschaltung von Schaltmodulen TU, die in einer Tragestruktur mit Turmscheiben T1-T14 angeordnet sind. Es ist hierbei der Unterschied zu der Anordnung der Figur 1 erkennbar. Es sind aufgrund der Turmscheiben-Anordnung keine freien Räume zwischen einzelnen Umrichtertürmen (2-5 in Figur 1) notwendig vorgesehen. Die einzelnen Turmscheiben können mit relativ kleinen Abständen an die bereits verbauten Turmscheiben angeschlossen werden. In Figur 2 sind in jeder Turmscheibe 4 Schaltmodule verbaut (sichtbar sind lediglich die beiden vorderen Schaltmodule). Deren Anzahl ist jedoch grundsätzlich so zu wählen, dass die Höhe der Turmscheibe optimal bezüglich des vorhandenen Raumes bsp. einer Umrichterhalle gewählt ist.

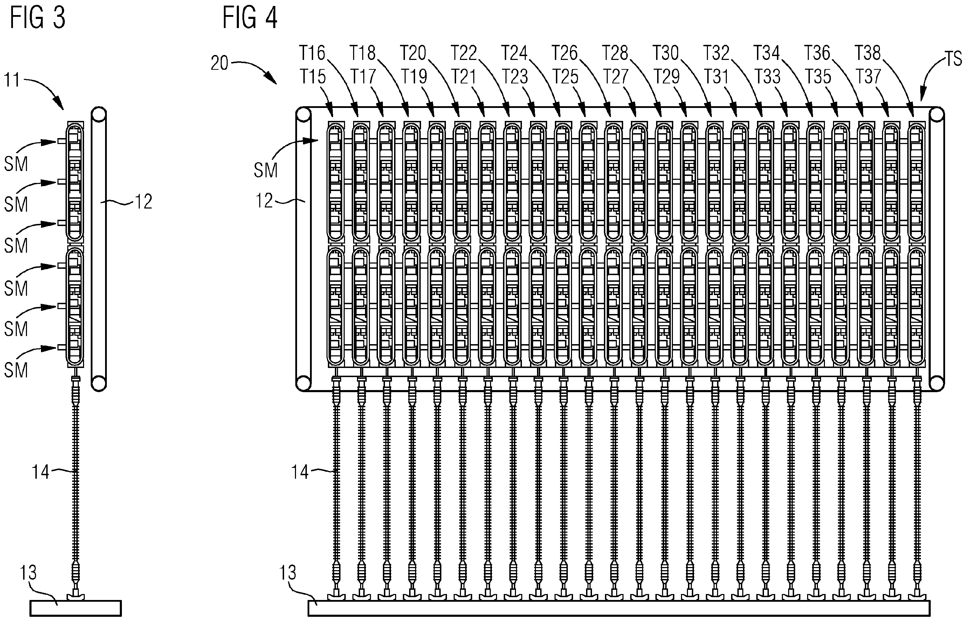

In Figur 3 ist eine einzelne Turmscheibe 11 in einer Frontanschicht dargestellt. Die Turmscheibe 11 umfasst 12 Schaltmodule SM (sichtbar sind hierbei die sechs vorderen Schaltmodule). Zudem umfasst die Turmscheibe 11 einen Koronaring 12 sowie Isolatorbeine zum Abstützen der Turmscheibe 11 am Boden 13 einer Umrichterhalle (in der Frontansicht der Figur 3 ist lediglich ein vorderes Isolatorbein 14 sichtbar).

Figur 4 zeigt eine Umrichteranordnung 20 mit einer Reihenschaltung von Schaltmodulen SM, die in einer Tragestruktur TS mit einer Vielzahl von Turmscheiben T15-T38 angeordnet sind. Die Turmscheiben T15-T38 entsprechend hierbei in ihrem Aufbau im Wesentlichen der in der Figur 3 gezeigten einzelnen Turmscheibe 11.

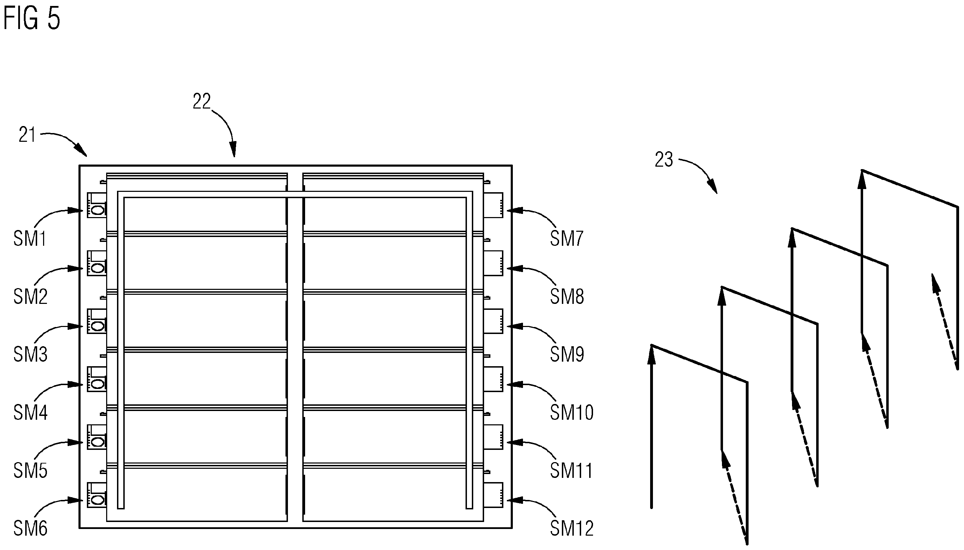

Figur 5 zeigt eine Umrichteranordnung 21 in einer Seitenansicht einer Turmscheibe 22, wobei die Verschaltung der Schaltmodule SM1-SM12 sichtbar gemacht ist. Jedes Schaltmodul SM1-12 hat ein rückseitig benachbartes Schaltmodul. Zum Beispiel ist das Schaltmodul SM1 rückseitig dem Schaltmodul SM7 benachbart. Zudem hat jedes Schaltmodul eines oder mehrere (hier zwei) vertikal benachbarte Schaltmodule. Beispielsweise sind Schaltmodule SM1 und SM3 zum Schaltmodul SM2 vertikal benachbart. Gemäß dem Ausführungsbeispiel der Figur 5 sind lediglich die Schaltmodule SM1 und SM7, die zueinander rückseitig benachbart sind, miteinander verbunden. Die Schaltmodule SM6 und SM12 sind Anschluss-Schaltmodule, die mit waagerecht benachbarten Schaltmodulen benachbarter Turmscheiben verbunden sind. Die übrigen Schaltmodule SM2-5, SM8-11 sind ausschließlich mit ihnen vertikal benachbarten Schaltmodulen verbunden.

Auf der rechten Seite der Figur 5 ist ein grundsätzlicher Verlauf 23 der Verschaltung schematisch dargestellt. Die unterbrochenen Linien zeigen die Verbindungen zwischen benachbarten Turmscheiben an. Durchgezogene Linien zeigen den Verlauf der elektrischen Verbindung innerhalb einer und derselben Turmscheibe an.

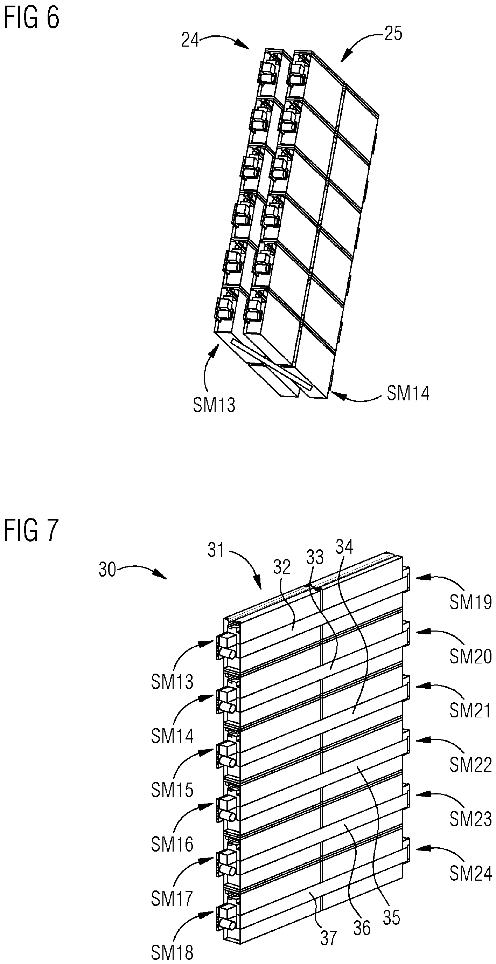

Figur 6 zeigt einen Ausschnitt zweier Benachbarter Turmscheiben 24 und 25 der Umrichteranordnung 21 der Figur 5. Es ist erkennbar, dass ein erstes Anschluss-Schaltmodul SM13 der ersten Turmscheibe 24 mit einem zweiten Anschluss-Schaltmodul SM14 der zweiten Turmscheibe 25 verbunden ist. Zu beachten ist, dass die beiden Anschluss-Schaltmodule SM13, SM14 zueinander nicht benachbart sind.

Allgemein ist anzumerken, dass jedes Schaltmodul zwei Schaltmodul-Anschlüsse aufweist, so dass jedes Schaltmodul mit zwei weiteren Schaltmodulen unter Bildung einer Reihenschaltung von Schaltmodulen verbunden ist.

Figur 7 zeigt ein weiteres Ausführungsbeispiel einer Umrichteranordnung 30 mit in einer Turmscheibe 31 angeordneten Schaltmodulen SM13-24. Bei dieser Ausführungsform sind alle Schaltmodule SM13-24 mit ihnen jeweils rückseitig benachbarten Schaltmodulen mittels Stromschienen 32-37 verbunden.

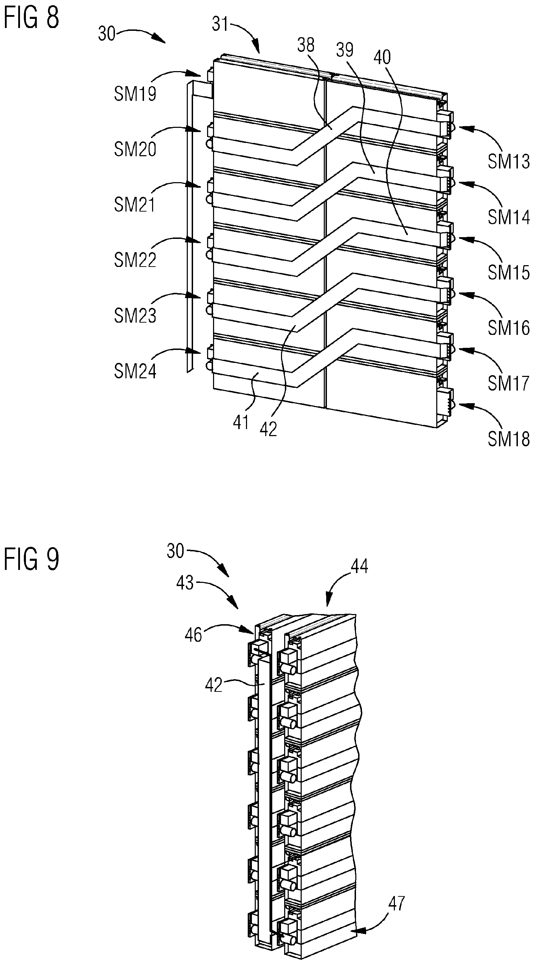

In Figur 8 ist eine seitenumgewandte Seitenansicht der Anordnung wie in Figur 7 gezeigt, dargestellt. Gleiche Elemente bezeichnende Bezugszeichen bleiben hierbei gleich. Erkennbar sind Stromschienen 38-42, die die Schaltmodule SM13-24 miteinander elektrisch verbinden.

Figur 9 zeigt eine weitere Teilansicht der Umrichteranordnung 30 der Figuren 7 und 8. In Figur 9 zwei benachbarte Turmscheiben 43, 44. Zudem ist eine Stromschiene 45 erkennbar, die ein erstes Anschluss-Schaltmodul 46 der ersten Turmscheibe 43 mit einem zweiten Anschluss-Schaltmodul 47 der zweiten Turmscheibe 44 verbindet.

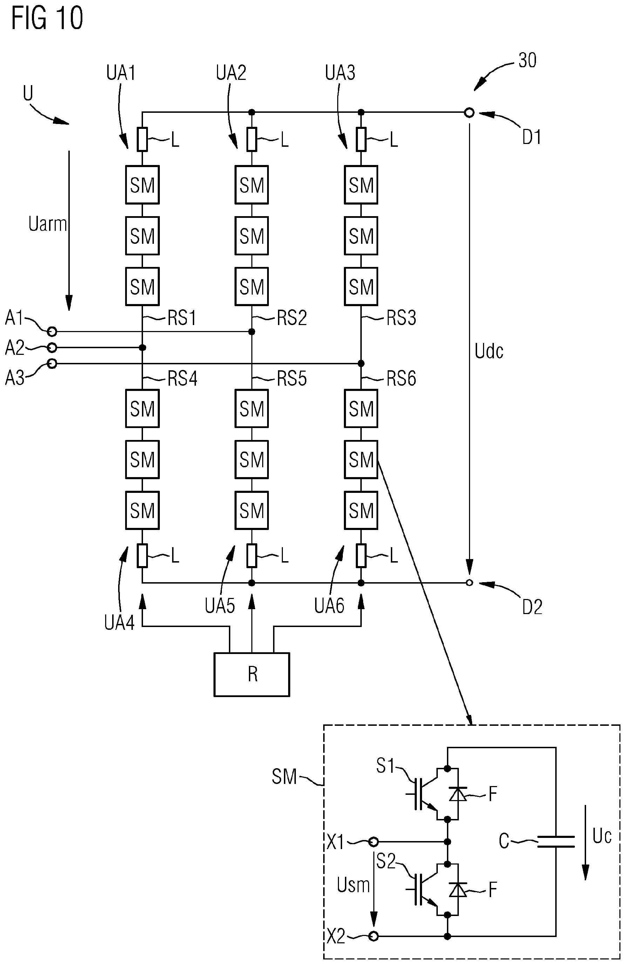

In Figur 10 ist eine Umrichteranordnung 30 mit einem Umrichter U dargestellt, der oftmals als modularer Mehrstufenumrichter (MMC) bezeichnet wird. Der Umrichter U umfasst sechs Umrichterarme UA1-6 mit Reihenschaltungen RS1-RS6, die jeweils eine Vielzahl von Schaltmodulen SM umfassen, sowie mit einer Induktivität L (Armdrossel). Der MMC ist im dargestellten Beispiel zur Umwandlung einer Wechselspannung eines Wechselspannungsnetzes, mit dem der MMC 1 beispielsweise mittels Anschlüsse A1-A3 sowie eines Netztransformators verbunden sein kann, in eine Gleichspannung UDC (oder umgekehrt) eingerichtet. Mittels der Anschlüsse D1, D2 kann der Umrichter U mit einem Gleichspannungsnetz bzw. einer Gleichspannungsleitung verbunden werden. Der Umrichter U umfasst ferner eine Regelungseinrichtung R, die zur Umrichterregelung eingerichtet ist. Dabei können Strom, Spannung, Leistung und Frequenz mittels der Regelungseinrichtung R geregelt werden. Zum Beispiel kann mittels der Regelungseinrichtung R eine Armspannung Uarm geregelt werden, wobei die Armspannung Uarm die an dem ersten Umrichterarm UA1 anstehende Spannung bezeichnet.

In dem in Figur 10 dargestellten Beispiel sind alle Schaltmodule SM gleichartig ausgebildet. Grundsätzlich ist es aber auch denkbar, dass unterschiedlich ausgebildete Schaltmodule in einem und demselben Stromrichter verwendet werden, beispielsweise Halbbrückenschaltmodule und Vollbrückenschaltmodule.

Figur 10 zeigt zudem ein Beispiel für ein Schaltmodul SM, das in den zuvor beschriebenen Umrichteranordnungen einsetzbar ist. Das Schaltmodul SM ist ein Halbbrücken-Schaltmodul. Das Schaltmodul SM umfasst einen Energiespeicherzweig, in dem ein erster Halbleiterschalter S1 mit einer antiparallelen Freilaufdiode F sowie in Reihe dazu ein Energiespeicher C angeordnet sind. In einem Brückenzweig zwischen zwei Anschlüssen X1, X2 des Schaltmoduls SM ist ein zweiter Halbleiterschalter S2 mit einer antiparallelen Freilaufdiode F angeordnet. Durch geeignete Ansteuerung der beiden Halbleiterschalter S1, S2 kann an den Anschlüssen X1, X2 eine Schaltmodulspannung Usm erzeugbar, die der Kondensatorspannung Uc oder aber einer Nullspannung entspricht. Die Halbleiterschalter S1, S2 sind Leistungshalbleiterschalter mit einer Nennspannung von 4kV. Die Halbleiterschalter S1, S3 sind im dargestellten Beispiel IGBTs, denkbar sind jedoch auch andere abschaltbare Halbleiterschalter, wie IGCTs, MOSFET oder auch sogenannte widegap-Halbleiterschalter.

## Patentansprüche

1. Umrichteranordnung (20) mit einer Reihenschaltung von Schaltmodulen (SM), wobei jedes Schaltmodul (SM) jeweils mehrere Halbleiterschalter (S1, S2), einen Energiespeicher (C) sowie einen ersten und einen zweiten Schaltmodulanschluss (X1,X2) zum Verbinden mit zwei weiteren Schaltmodulen (SM) aufweist, wobei die Schaltmodule (SM) in einer Tragestruktur (TS) angeordnet sind,
**dadurch gekennzeichnet, dass** die Tragestruktur (TS) nebeneinander aufgestellte Turmscheiben (T15-T38) umfasst, so dass jedem Schaltmodul (SM) wenigstens ein waagerecht benachbartes, wenigstens ein vertikal benachbartes Schaltmodul (SM) sowie genau ein rückseitig benachbartes Schaltmodul (SM) zugeordnet sind,
wobei jede Turmscheibe (T15-T38) zwei Anschluss-Schaltmodule aufweist, so dass alle Schaltmodule (SM) mit Ausnahme der Anschluss-Schaltmodule mittels ihrer Schaltmodulanschlüsse (X1,X2) ausschließlich mit ihnen vertikal oder rückseitig benachbarten Schaltmodulen (SM) verbunden sind.

2. Umrichteranordnung nach Anspruch 1, wobei je Turmscheibe (T15-T38) lediglich zwei rückseitig benachbarte Schaltmodule (SM) miteinander elektrisch verbunden sind.

3. Umrichteranordnung nach Anspruch 1, wobei die Schaltmodule (SM) jeweils mit dem ihnen zugeordneten rückseitig benachbarten Schaltmodul (SM) elektrisch verbunden sind.

4. Umrichteranordnung nach einem der vorangehenden Ansprüche, wobei jede Turmscheibe (T15-T38) zwischen zehn und zwanzig Schaltmodule (SM) umfasst.

5. Umrichteranordnung (20) nach einem der vorangehenden Ansprüche, wobei die Umrichteranordnung (20) mehr als zwanzig Turmscheiben (T15-T38) umfasst.

6. Umrichteranordnung (20) nach einem der vorangehenden Ansprüche, wobei jede Turmscheibe (T15-T38) Isolatorbeine (14) umfasst, die die Turmscheibe (T15-T38) am Boden abstützen und die Schaltmodule (SM) der Turmscheibe (T15-T38) vom Grundpotenzial elektrisch isolieren.

7. Umrichteranordnung (20) nach einem der vorangehenden Ansprüche, wobei die Schaltmodule (SM) Halbbrücken- oder Vollbrückenschaltmodule sind.

8. Umrichteranordnung (20) nach einem der vorangehenden Ansprüche, wobei jedes Schaltmodul (SM) auf eine Spannung von mindestens 2kV, bevorzugt mindestens 4kV ausgelegt ist.

9. Umrichteranordnung (20) nach einem der vorangehenden Ansprüche, wobei die Turmscheiben (T15-T38) jeweils eine Höhe von mindestens 5m aufweisen.

10. Umrichteranordnung (20) nach einem der vorangehenden Ansprüche, wobei die Umrichteranordnung (20) zum Umwandeln einer Wechselspannung in eine Gleichspannung oder umgekehrt eingerichtet ist.
